(19) Europäisches Patentamt
European Patent Office
Office européen des brevets

(11) **EP 4 697 385 A1**

(12) **EUROPEAN PATENT APPLICATION**
published in accordance with Art. 153(4) EPC

(43) Date of publication:
**18.02.2026 Bulletin 2026/08**

(21) Application number: **24788624.5**

(22) Date of filing: **02.04.2024**

(51) International Patent Classification (IPC):
**H01L 27/146** (2006.01)  **H04N 25/70** (2023.01)

(52) Cooperative Patent Classification (CPC):
**H04N 25/70; H10F 39/12**

(86) International application number:
**PCT/JP2024/013630**

(87) International publication number:
**WO 2024/214597 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.04.2023 JP 2023065642**

(71) Applicant: **Panasonic Intellectual Property
Management Co., Ltd.
Kadoma-shi, Osaka 571-0057 (JP)**

(72) Inventors:
• **MITSUISHI, Morio
Kadoma-shi, Osaka 571-0057 (JP)**
• **AOYAMA, Kenichi
Kadoma-shi, Osaka 571-0057 (JP)**
• **IIJIMA, Hiroaki
Kadoma-shi, Osaka 571-0057 (JP)**
• **MOMOSE, Tatsunori
Kadoma-shi, Osaka 571-0057 (JP)**

(74) Representative: **Grünecker Patent- und
Rechtsanwälte
PartG mbB
Leopoldstraße 4
80802 München (DE)**

(54) **IMAGING DEVICE**

(57) An imaging device includes pixels 24. Each of the pixels 24 includes: a lower electrode 2; an upper electrode 5 that is disposed to face the lower electrode 2; and a photoelectric conversion layer 4 that is positioned between the lower electrode 2 and the upper electrode 5, includes a donor semiconductor material and an acceptor semiconductor material, and generates electrons and holes. Between the lower electrode 2 and the upper electrode 5, a first bias voltage is applied in a first period that is an exposure period and a second bias voltage that is different from the first bias voltage is applied in a second period that is a non-exposure period. $(C2 - C1)/C1 \leq 1$ is satisfied, where C1 is a capacitance between the lower electrode 2 and the upper electrode 5 when the first bias voltage is applied between the lower electrode 2 and the upper electrode 5, and C2 is the capacitance between the lower electrode 2 and the upper electrode 5 when the second bias voltage is applied between the lower electrode 2 and the upper electrode 5.

FIG. 5

## Description

Technical Field

The present disclosure relates to an imaging device.

Background Art

Stacked imaging devices have been proposed as metal oxide semiconductor (MOS) imaging devices. In the stacked imaging devices, a photoelectric conversion element including a photoelectric conversion layer is stacked above a semiconductor substrate, and charges generated by photoelectric conversion in the photoelectric conversion layer are collected by an electrode and accumulated in a charge accumulation region. For example, PTL 1 discloses a stacked imaging device that reads out charges accumulated in a charge accumulation region by using a charge coupled device (CCD) circuit or a complementary MOS (CMOS) circuit in a semiconductor substrate.

A photoelectric conversion element used in an imaging device usually has a structure in which functional layers, such as a photoelectric conversion layer that absorbs light and generates signal charges and a charge blocking layer that suppresses injection of charges from an electrode, are stacked. For example, PTL 2 discloses an imaging device using a photoelectric conversion element having a structure in which a photoelectric conversion layer and a charge blocking layer are stacked.

In a CMOS image sensor including a photodiode, generally, a so-called rolling shutter method, with which exposure to light and readout of signal charges are sequentially performed for each row of a pixel array, is used as a method of reading out signals.

In the rolling shutter method, the timing of starting and finishing exposure to light differs from row to row of the pixel array. Therefore, it may occur that a distorted image of an object may be obtained when the image is captured while the object is moving at high speed or difference in brightness may occur in an image when a flashlight is used. In such circumstances, demand for a so-called global shutter function, with which start and finish of exposure to light are performed at the same timing for all pixels in a pixel array, has been growing in recent years.

For example, PTL 3 discloses a method for realizing a global shutter function by using a photoelectric conversion element including an organic-material thin film. The method includes applying, between electrodes disposed at both ends of the photoelectric conversion element, a first bias voltage for moving signal charges generated in the photoelectric conversion element to an electrode and, in addition, a second bias voltage for suppressing movement of charges at a timing of reading out the moved signal charges by using a signal detection circuit.

Citation List

Patent Literature

PTL 1: Japanese Unexamined Patent Application Publication No. 2007-311647
PTL 2: Japanese Unexamined Patent Application Publication No. 2012-94660
PTL 3: Japanese Unexamined Patent Application Publication No. 2018-92990

Summary of Invention

Imaging devices are used in various environments. For example, regarding an imaging device for monitoring or for a vehicle, which is used in an imaging environment in which brightness changes considerably, it is required that the imaging device perform high-quality imaging irrespective of the imaging environment. That is, in the performance of an imaging device, it is important that the imaging device have a wide dynamic range. The dynamic range is determined by the saturation signal quantity and noise of the imaging device, and it is possible to realize a wide dynamic range by increasing the saturation signal quantity and/or by reducing the noise. Reduction of noise is also important in improving the quality of a captured image.

The present disclosure provides an imaging device in which noise is reduced.

An imaging device according to an aspect of the present disclosure includes pixels. Each of the pixels includes: a first electrode; a second electrode that is disposed to face the first electrode; and a photoelectric conversion layer that is positioned between the first electrode and the second electrode, includes a donor semiconductor material and an acceptor semiconductor material, and generates electrons and holes. Between the first electrode and the second electrode, a first bias voltage is applied in a first period that is an exposure period and a second bias voltage that is different from the first bias voltage is applied in a second period that is a non-exposure period. $(C2 - C1)/C1 \leq 1$ is satisfied, where C1 is a capacitance between the first electrode and the second electrode when the first bias voltage is applied between the first electrode and the second electrode, and C2 is the capacitance between the first electrode and the second electrode when the second bias voltage is applied between the first electrode and the second electrode.

An imaging device according to an aspect of the present disclosure includes pixels. Each of the pixels includes: a first electrode; a second electrode that is disposed to face the first electrode; a photoelectric conversion layer that is positioned between the first electrode and the second electrode, includes a donor semiconductor material and an acceptor semiconductor material, and generates electrons and holes; a first charge blocking layer that is positioned between the first electrode and the photoelectric conversion layer; and a charge accumulation region that is electrically connected to the first electrode and accumulates signal charges that are either the holes or the electrons. Between the first electrode and the second electrode, a first bias voltage is applied in a first period and a second bias voltage that is different from the first bias voltage is applied in a second period. A thickness of the first charge blocking layer is greater than or equal to 25% of a shortest distance between the first electrode and the second electrode.

With the present disclosure, it is possible to provide an imaging device in which noise is reduced.

Brief Description of Drawings

[Fig. 1] Fig. 1 is a schematic sectional view illustrating the configuration of a photoelectric conversion element according to an embodiment.
[Fig. 2] Fig. 2 is an exemplary energy band diagram of the photoelectric conversion element according to the embodiment.
[Fig. 3] Fig. 3 is a schematic sectional view illustrating the configuration of another photoelectric conversion element according to the embodiment.
[Fig. 4] Fig. 4 illustrates an example of the circuit configuration of an imaging device according to an embodiment.
[Fig. 5] Fig. 5 is a schematic sectional view illustrating the device structure of a pixel of the imaging device according to the embodiment.
[Fig. 6] Fig. 6 is an exemplary energy band diagram of a photoelectric converter when a first bias voltage is applied between a lower electrode and an upper electrode.
[Fig. 7] Fig. 7 is an exemplary energy band diagram of the photoelectric converter when a second bias voltage is applied between the lower electrode and the upper electrode.
[Fig. 8] Fig. 8 is a graph schematically illustrating an example of the capacitance-voltage characteristics (C-V characteristics) of the photoelectric converter.
[Fig. 9] Fig. 9 is a graph conceptually illustrating the distribution of the quantity of charges accumulated in the photoelectric converter.
[Fig. 10] Fig. 10 is a graph illustrating the relationship between (C2 - C1)/C1 and random noise in imaging devices according to Examples and Comparative Example.
[Fig. 11] Fig. 11 is a graph illustrating the relationship between D2/D1 and random noise in the imaging devices according to Examples and Comparative Example. Description of Embodiments

(Underlying Knowledge Forming Basis of the Present Disclosure)

The inventors have found that it is necessary to address the following problems in order to provide an imaging device in which noise is reduced.

As in the global shutter function disclosed in PTL 3, when two types of bias voltages are applied between the electrodes disposed at both ends of the photoelectric conversion element, the quantity of charges accumulated in the photoelectric conversion element varies due to the two types of bias voltages. For example, in a period when the first bias voltage is applied, the quantity of charges accumulated in the photoelectric conversion element is small, because a bias voltage for moving charges to an electrode is applied. On the other hand, in a period when the second bias voltage is applied, the quantity of charges accumulated in the photoelectric conversion element is large, because a bias voltage for suppressing movement of charges is applied. When two types of bias voltages are applied, if the quantity of charges accumulated in the photoelectric conversion element in a period when one of the bias voltages are applied varies and increases considerably compared with a period when the other bias voltage is applied, dispersion of the quantity of charges accumulated in the photoelectric conversion element increases. Because one of the electrodes of the photoelectric conversion element is electrically connected to a charge accumulation region that accumulates signal charges to be read out as signals, dispersion of the quantity of charges accumulated in the photoelectric conversion element influences the charge accumulation region, and becomes a factor in generation of noise in the imaging device.

The present disclosure has been made based on such findings and provides an imaging device in which is noise is reduced by reducing variation in the quantity of charges accumulated in the photoelectric conversion element.

(Overview of Present Disclosure)

As an outline of an aspect of the present disclosure, examples of an imaging device according to the present disclosure will be described below.

An imaging device according to a first aspect of the present disclosure includes pixels. Each of the pixels includes: a first electrode; a second electrode that is disposed to face the first electrode; and a photoelectric conversion layer that is positioned between the first electrode and the second electrode, includes a donor semiconductor material and an acceptor semiconductor material, and generates electrons and holes. Between the first electrode and the second electrode, a first bias voltage is applied in a first period that is an exposure period and a second bias voltage that is different from the first bias voltage is applied in a second period that is a non-exposure period. (C2 - C1)/C1 ≤ 1 is satisfied, where C1 is a capacitance between the first electrode and the second electrode when the first bias voltage is applied between the first electrode and the second electrode, and C2 is the capacitance between the first electrode and the second electrode when the second bias voltage is applied between the first electrode and the second electrode.

With the configuration of the present aspect, it is possible to realize an imaging device in which noise is reduced.

To be specific, noise can be reduced by reducing variation in the quantity of charges accumulated between the first electrode and the second electrode. In a global shutter function and the like, variation in the quantity of charges accumulated between the first electrode and the second electrode when two different types of bias voltages are applied is proportional to variation in the capacitance between the first electrode and the second electrode. Therefore, when the difference in capacitance when the first bias voltage and the second bias voltage, which differ from each other, are applied between the first electrode and the second electrode is less than or equal to the capacitance between the first electrode and the second electrode when the first bias voltage is applied, variation in the quantity of charges between the first electrode and the second electrode can be reduced. As a result, because it is possible to reduce the quantity of charges accumulated between the first electrode and the second electrode even in a period when the second bias voltage is applied, sufficient noise reduction can be realized.

For example, an imaging device according to a second aspect of the present disclosure is the imaging device according to the first aspect, in which a photoelectric conversion efficiency of the pixels in the first period is different from the photoelectric conversion efficiency of the pixels in the second period.

Thus, even when the first bias voltage and the second bias voltage, which differ in variation in the quantity of charges generated in the photoelectric conversion layer in accordance with the intensity of light the enters the photoelectric conversion layer, are applied between the first electrode and the second electrode in the first period and the second period, the imaging device can realize sufficient noise reduction as described above.

For example, an imaging device according to a third aspect of the present disclosure is the imaging device according to the first or second aspect, in which the imaging device operates by using a global shutter method in which all exposure periods of the pixels are uniform, each of the pixels further includes a charge accumulation region that is electrically connected to the first electrode and accumulates signal charges that are either the electrons or the holes, and the first period is a period for accumulating the signal charges in the charge accumulation region.

Thus, because it is possible to expose all pixels to light at the same timing, sufficient noise reduction can be realized while suppressing occurrence of a phenomenon, such as distortion of an image, that is peculiar to a rolling shutter method.

For example, an imaging device according to a fourth aspect of the present disclosure is the imaging device according to the third aspect, in which the electrons and the holes in the photoelectric conversion layer recombine when the second bias voltage is applied between the first electrode and the second electrode.

In this way, because the second bias voltage that causes electrons and holes to recombine is supplied in the second period, by using the second period, which is a non-exposure period, as a signal readout period, charges generated in the photoelectric conversion layer become less likely to be influenced by the intensity of light the enters the photoelectric conversion layer in the non-exposure period.

For example, an imaging device according to a fifth aspect of the present disclosure is the imaging device according to the third or fourth aspect, in which the photoelectric conversion layer has photoelectric conversion sensitivity when the first bias voltage is applied between the first electrode and the second electrode.

In this way, because the first bias voltage with which the photoelectric conversion layer has sensitivity is supplied in the first period, which is an exposure period, imaging can be performed by using a global shutter method.

For example, an imaging device according to a sixth aspect of the present disclosure is the imaging device according to any one of the first to fifth aspects, further including a voltage supply circuit that selectively applies, between the first electrode and the second electrode, a bias voltage such that a potential of the second electrode relative to the first electrode becomes a positive potential and a bias voltage such that the potential of the second electrode relative to the first electrode becomes a negative potential.

In this way, even when a bias voltage such that the potential of the second electrode relative to the first electrode becomes a positive potential or a negative potential is applied between the first electrode and the second electrode, the imaging device can realize sufficient noise reduction.

An imaging device according to a seventh aspect of the present disclosure includes pixels. Each of the pixels includes: a first electrode; a second electrode that is disposed to face the first electrode; a photoelectric conversion layer that is positioned between the first electrode and the second electrode, includes a donor semiconductor material and an acceptor semiconductor material, and generates electrons and holes; a first charge blocking layer that is positioned between the first electrode and the photoelectric conversion layer; and a charge accumulation region that is electrically connected to the first electrode and accumulates signal charges that are either the holes or the electrons. Between the first electrode and the second electrode, a first bias voltage is applied in a first period and a second bias voltage that is different from the first bias voltage is applied in a second period. A thickness of the first charge blocking layer is greater than or equal to 25% of a shortest distance between the first electrode and the second electrode.

With the configuration of the present aspect, it is possible to realize an imaging device in which noise is reduced.

To be specific, noise can be reduced by reducing variation in the quantity of charges accumulated between the first electrode and the second electrode. In a case where a charge blocking layer is provided between the first electrode and the photoelectric conversion layer, when a bias voltage for suppressing movement of charges is applied between the first electrode and the second electrode, charges accumulate in the vicinity of the interface between the photoelectric conversion layer and the first charge blocking layer. That is, it is possible to regard each pixel as a capacitor that has the first charge blocking layer as a dielectric and in which charges are accumulated in the vicinity of the interface between the first electrode and the photoelectric conversion layer and in the vicinity of the interface between the photoelectric conversion layer and the first charge blocking layer. On the other hand, when a bias voltage that moves charges to an electrode is applied between the first electrode and the second electrode, the quantity of charges accumulated between the first electrode and the second electrode is small. That is, it is possible to regard each pixel in this state as a capacitor that stores charges between the first electrode and the second electrode. Thus, variation in the quantity of charges accumulated between the first electrode and the second electrode when different voltages are applied depends on the ratio of the thickness of the first charge blocking layer to the shortest distance between the first electrode and the second electrode. Because the first electrode is electrically connected to the charge accumulation region, when the thickness of the first charge blocking layer is greater than or equal to 25% of the shortest distance between the first electrode and the second electrode, variation in the quantity of charges between the first electrode and the second electrode can be reduced. As a result, it is possible to reduce the quantity of charges accumulated between the first electrode and the second electrode even in a period when the second bias voltage is applied, and it is possible to reduce the influence of charges accumulated between the first electrode and the second electrode on the charge accumulation region and to realize sufficient noise reduction.

For example, an imaging device according to an eighth aspect of the present disclosure is the imaging according to the seventh aspect, in which the thickness of the first charge blocking layer is greater than or equal to 10 nm.

Thus, even when there is a large potential difference between the first electrode and the second electrode, it is possible to realize sufficient noise reduction while suppressing leakage current from the first electrode to the photoelectric conversion layer.

For example, an imaging device according to a ninth aspect of the present disclosure is the imaging device according to the seventh or eighth aspect, in which the signal charges are the holes, the first charge blocking layer includes a first semiconductor material, and a difference between an ionization potential of the first semiconductor material included in the first charge blocking layer and an ionization potential of the donor semiconductor material included in the photoelectric conversion layer is less than or equal to 1 eV.

For example, an imaging device according to a tenth aspect of the present disclosure is the imaging device according to the seventh or eighth aspect, in which the signal charges are the electrons, the first charge blocking layer includes a first semiconductor material, and a difference between an electron affinity of the first semiconductor material included in the first charge blocking layer and an electron affinity of the acceptor semiconductor material included in the photoelectric conversion layer is less than or equal to 1 eV.

Thus, it is possible to realize sufficient noise reduction while increasing the efficiency in extracting signal charges generated in the photoelectric conversion layer to the first electrode.

For example, an imaging device according to an eleventh aspect of the present disclosure is the imaging device according to any one of the eighth to tenth aspects, in which each of the pixels further includes a second charge blocking layer that is positioned between the second electrode and the photoelectric conversion layer.

Thus, it is possible to realize sufficient noise reduction while suppressing leakage current from the second electrode to the photoelectric conversion layer.

For example, an imaging device according to a twelfth aspect of the present disclosure is the imaging device according to the eleventh aspect, in which a thickness of the second charge blocking layer is greater than or equal to 5 nm.

Thus, even when there is a large potential difference between the first electrode and the second electrode, it is possible to realize sufficient noise reduction while suppressing leakage current from the second electrode to the photoelectric conversion layer.

For example, an imaging device according to a thirteenth aspect of the present disclosure is the imaging device according to the eleventh or twelfth aspect, in which the signal charges are the holes, the second charge blocking layer includes a second semiconductor material, and a difference between an electron affinity of the second semiconductor material included in the second charge blocking layer and an electron affinity of the acceptor semiconductor material included in the photoelectric conversion layer is less than or equal to 1 eV.

For example, an imaging device according to a fourteenth aspect of the present disclosure is the imaging device according to the eleventh or twelfth aspect, in which the signal charges are the electrons, the second charge blocking layer includes a second semiconductor material, and a difference between an ionization potential of the second semiconductor material included in the second charge blocking layer and an ionization potential of the donor semiconductor material included in the photoelectric conversion layer is less than or equal to 1 eV.

Thus, the efficiency in transporting charges whose polarity is opposite to that of signal charges generated in the photoelectric conversion layer to the second electrode is increased, and it is possible to realize sufficient noise reduction while suppressing decrease of sensitivity due to recombination of signal charges generated in the photoelectric conversion layer with charges whose polarity is opposite to that signal charges.

Hereafter, embodiments will be described with reference to the drawings.

The embodiments described below each represent a general or specific example. The values, shapes, constituent elements, arrangements of constituent elements, positions and connection configurations of constituent elements, steps, order of steps, and the like described in the following embodiments are examples, and do not limit the present disclosure. Among the constituent elements in the embodiments, constituent elements that are not described in the independent claims are optional constituent elements. Each figure is not necessarily drawn strictly. In the figures, substantially the same configurations are denoted by the same numerals, and redundant descriptions thereof may be omitted or simplified.

In the present specification, terms that represent the relationships between elements such as "perpendicular", terms that represent the shapes of elements such as "rectangular", and numerical ranges not only have strict meanings but also have substantially equivalent meanings.

In the present specification, the terms "above" and "below" do not represent the upward direction (vertically above) and the downward direction (vertically below) in absolute spatial recognition, but are used as terms that are defined by a relative positional relationship based on the stacked order in a stacked configuration. The terms "above", "below", and the like are only used to specify relative arrangement of members and do not limit the position of an imaging device when the imaging device is used. The terms "above" and "below" are used, not only when two constituent elements are disposed with a space therebetween and another constituent element is present between the two constituent elements, but also when two constituent elements are disposed very close to each other and the two constituent elements are in close contact with each other.

In the present specification, for convenience, the term "light" refers to electromagnetic radiation in general, including visible light, infrared radiation, and ultraviolet radiation.

(Embodiments)

Hereafter, the present embodiment will be described.

[Photoelectric Conversion Element]

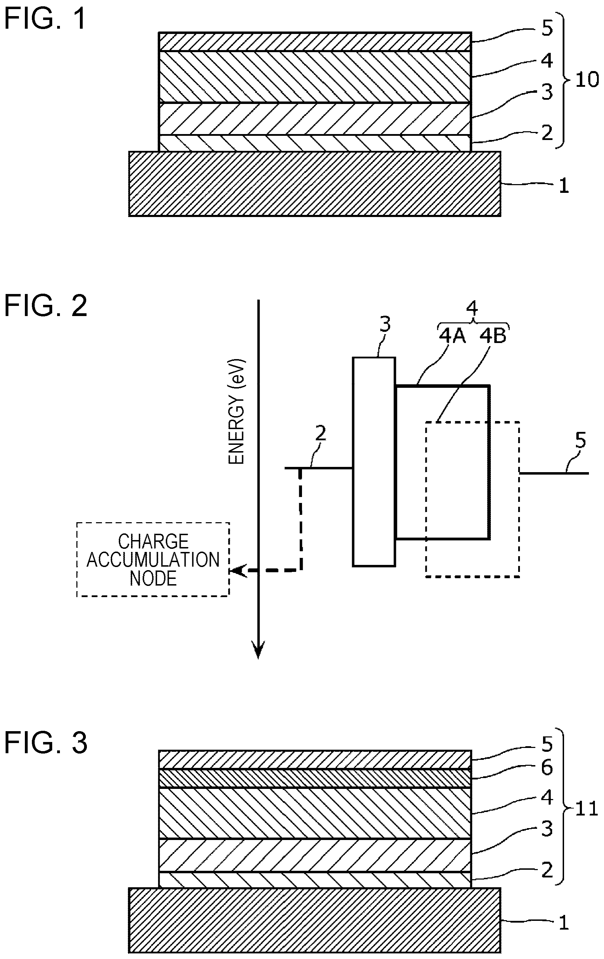

First, referring to Fig. 1, a photoelectric conversion element included in an imaging device according to the present embodiment will be described. The photoelectric conversion element according to the present embodiment is a charge-readout photoelectric conversion element. Fig. 1 is a schematic sectional view illustrating the configuration of a photoelectric conversion element 10 according to the present embodiment.

As illustrated in Fig. 1, the photoelectric conversion element 10 is supported by a support substrate 1, and includes an upper electrode 5 and a lower electrode 2 that are a pair of electrodes, a photoelectric conversion layer 4 between the upper electrode 5 and the lower electrode 2, and a charge blocking layer 3 positioned between the lower electrode 2 and the photoelectric conversion layer 4. In the present embodiment, the lower electrode 2 is an example of a first electrode, and the upper electrode 5 is an example of a second electrode. The charge blocking layer 3 is an example of a first charge blocking layer.

The photoelectric conversion element 10 is used, for example, in a position such that light that has passed through the upper electrode 5 enters the photoelectric conversion layer 4.

Hereafter, each constituent element of the photoelectric conversion element 10 according to the present embodiment will be described.

The support substrate 1 may be any substrate that is used to support a general photoelectric conversion element, and may be, for example, a glass substrate, a quartz substrate, a semiconductor substrate, a plastic substrate, or the like.

The lower electrode 2 and the upper electrode 5 are film-like electrodes that are disposed to face each other.

The lower electrode 2 collects signal charges generated by the photoelectric conversion layer 4. The lower electrode 2 is made of a metal, a metal nitride, a metal oxide, a polysilicon provided with electroconductivity, or the like. Examples of the metal include aluminum, copper, titanium, and tungsten. Examples of a method for providing a polysilicon with electroconductivity include doping the polysilicon with an impurity.

The upper electrode 5 is disposed to face the lower electrode 2 with the photoelectric conversion layer 4 therebetween. The upper electrode 5 is, for example, a transparent electrode made from a transparent electroconductive material. Examples of the material of the upper electrode 5 include transparent conducting oxide (TCO), indium tin oxide (ITO), indium zinc oxide (IZO), aluminum-doped zinc oxide (AZO), fluorine-doped tin oxide (FTO), $SnO_2$, and $TiO_2$. In accordance with a desirable transmittance, the upper electrode 5 may be made from TCO, a metal material such as aluminum (Al) or gold (Au), or a combination of such metal materials.

The materials of the lower electrode 2 and the upper electrode 5 are not limited to the electroconductive materials described above, and may be other materials. For example, the lower electrode 2 may be a transparent electrode.

Various methods are used to make the lower electrode 2 and the upper electrode 5 in accordance with the materials used. For example, when ITO is used, an electron beam method, a sputtering method, a resistance-heating deposition method, a chemical reaction method such as a sol-gel method, an indium-tin-oxide dispersion application method, or the like may be used. In this case, after an ITO film has been formed, UV-ozone treatment, plasma treatment, or the like may be additionally performed to make the lower electrode 2 and the upper electrode 5.

The photoelectric conversion layer 4 generates electrons and holes by absorbing light. Either the electrons or the holes are used as signal charges. That is, the photoelectric conversion layer 4 converts light into signal charges.

The photoelectric conversion layer 4 includes, for example, a donor semiconductor material and an acceptor semiconductor material. The photoelectric conversion layer 4 is made by using, for example, an organic semiconductor material. As a method of making the photoelectric conversion layer 4, it is possible to use, for example, a wet method such as an application method by spin coating or a dry method such as a vapor deposition method. A vapor deposition method is a method with which the material of a layer is evaporated and deposited on a substrate by heating the material in vacuum. It is also possible to make the charge blocking layer 3 by using a method similar to a method of making the photoelectric conversion layer 4.

The photoelectric conversion layer 4 is, for example, a mixture film having a bulk-hetero structure and including a donor semiconductor material such as a donor organic semiconductor material and an acceptor semiconductor material such as an acceptor organic semiconductor material. The photoelectric conversion layer 4 may have a stacked structure in which a layer of a donor semiconductor material and a layer of an acceptor semiconductor material are stacked.

The photoelectric conversion layer 4 can be easily formed as a thin film by including a donor organic semiconductor material and an acceptor organic semiconductor material. Hereafter, specific examples of a donor organic semiconductor material and an acceptor organic semiconductor material will be listed.

Examples of a donor organic semiconductor material include triarylamine compounds, benzidine compounds, pyrazoline compounds, styrylamine compounds, hydrazone compounds, triphenylmethane compounds, carbazole compounds, polysilane compounds, thiophene compounds, phthalocyanine compounds, naphthalocyanine compounds, subphthalocyanine compounds, cyanine compounds, merocyanine compounds, oxonol compounds, polyamine compounds, indole compounds, pyrrole compounds, pyrazole compounds, biphenyl compounds, terphenyl compounds, polyarylene compounds, fused aromatic carbocyclic compounds, and metal complexes including a nitrogen-containing heterocyclic compound as a ligand.

Examples of fused aromatic carbocyclic compounds include naphthalene derivatives, anthracene derivatives, phenanthrene derivatives, tetracene derivatives, pyrene derivatives, perylene derivatives, and fluoranthene derivatives.

Examples of an acceptor organic semiconductor material include: fullerenes; fullerene derivatives; fused aromatic carbocyclic compounds; 5- to 7-membered heterocyclic compounds containing a nitrogen atom, an oxygen atom, and/or a sulfur atom; polyarylene compounds; fluorene compounds; cyclopentadiene compounds; silyl compounds; and metal complexes including a nitrogen-containing heterocyclic compound as a ligand.

Examples of fullerenes include C60 fullerene and C70 fullerene.

Examples of fullerene derivatives include phenyl C61 butyric acid methyl ester (PCBM) and indene-C60 bisadduct (ICBA).

Examples of 5- to 7-membered heterocyclic compounds containing a nitrogen atom, an oxygen atom, and/or a sulfur atom include: pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyrrolidine, pyrrolopyridine, thiadiazolopyridine, dibenzazepine, and tribenzazepine.

A donor organic semiconductor material and an acceptor organic semiconductor material are not limited to the above examples. Any low-molecular-weight or high-molecular-weight organic compound may be used as a donor organic semiconductor material or an acceptor organic semiconductor material of the photoelectric conversion layer 4, as long as the organic compound can be formed into a photoelectric conversion layer by using either a dry method or a wet method.

The photoelectric conversion layer 4 may include a material other than an organic semiconductor material as a donor semiconductor material or an acceptor semiconductor material. The photoelectric conversion layer 4 may include, as a semiconductor material, a silicon semiconductor, a compound semiconductor, quantum dots, a perovskite material, carbon nanotubes, or a mixture of two or more of these.

As described above, the photoelectric conversion element 10 according to the present embodiment includes the charge blocking layer 3 between the lower electrode 2 and the photoelectric conversion layer 4. The charge blocking layer 3 is, for example, in contact with the lower electrode 2 and the photoelectric conversion layer 4.

The charge blocking layer 3 includes, for example, a first semiconductor material. The first semiconductor material is, for example, an organic semiconductor material. The organic semiconductor material is, for example, the aforementioned donor organic semiconductor material or acceptor organic semiconductor material. The first semiconductor material of the charge blocking layer 3 is not limited to an organic semiconductor material, may be an oxide semiconductor, a nitride semiconductor, or the like, or may be a composite material of these. The material of the charge blocking layer 3 may be, for example, a metal oxide such as aluminum oxide.

The charge blocking layer 3 may have a structure in which layers are stacked. In this case, the materials of the layers may be the same, or may be different from each other.

The thickness of the charge blocking layer 3 is set, for example, in accordance with the shortest distance between the lower electrode 2 and the upper electrode 5 as described below. The thickness of the charge blocking layer 3 is, for example, greater than or equal to 10 nm. In view of effective suppression of dark current and noise, the thickness of the charge blocking layer 3 may be greater than or equal to 20 nm, may be greater than or equal to 100 nm, may be greater than or equal to 150 nm, or may be greater than or equal to 200 nm. In view of suppression of decrease of sensitivity, the thickness of the charge blocking layer 3 may be less than or equal to 1000 nm or may be less than or equal to 600 nm.

Fig. 2 is an exemplary energy band diagram of the photoelectric conversion element illustrated in Fig. 1. In Fig. 2, the energy band of each layer is represented by a rectangle.

When irradiated with light, the photoelectric conversion layer 4 generates excitons therein. The generated excitons diffuse in the photoelectric conversion layer 4 and are separated into electrons and holes at the interface between an acceptor semiconductor material and a donor semiconductor material. When a voltage is applied between the upper electrode 5 and the lower electrode 2 so that the potential of the upper electrode 5 becomes higher than the potential of the lower electrode 2, electrons move toward the upper electrode 5 and holes move toward the lower electrode 2. When the photoelectric conversion element 10 is used for an imaging device, for example, holes are collected by the lower electrode 2 and are accumulated as signal charges in a charge accumulation node that is electrically connected to the lower electrode 2. The charge accumulation node is an example of a charge accumulation region that accumulates signal charges collected by the lower electrode 2. In this way, the photoelectric conversion layer 4 converts light into signal charges, and the lower electrode 2 collects signal charges generated by the photoelectric conversion layer 4. The upper electrode 5 collects charges whose polarity is opposite to that of signal charges. Hereafter, a case where holes moves toward the lower electrode 2 and holes are used as signal charges will be described. However, electrons may be used as signal charges. In this case, a voltage is applied between the upper electrode 5 and the lower electrode 2 so that the potential of the upper electrode 5 becomes lower than the potential of the lower electrode 2, holes move toward the upper electrode 5, and electrons move toward the lower electrode 2.

Here, the term "donor material" refers to a material that provides electrons, among the pairs of electrons and holes generated by absorbing light, to another material, and the term "acceptor material" refers to a material that accepts the electrons. In the present embodiment, the donor semiconductor material is a donor material, and the acceptor semiconductor material is an acceptor material. When two different organic semiconductor materials are used, which of these is a donor material and which of these is an acceptor material are determined by the relative positions of the energy levels of highest-occupied-molecular-orbital (HOMO) and lowest-unoccupied-molecular-orbital (LUMO) of the two organic semiconductor materials at the contact interface. In Fig. 2, in each rectangle representing the energy band, the upper end is the energy level of LUMO and the lower end is the energy level of HOMO. The energy difference between the vacuum level and the energy level of LUMO is called the electron affinity. The energy difference between the vacuum level and the energy level of HOMO is called the ionization potential. In Fig. 2, the lower the position, the greater the electron affinity and the ionization potential. The same applies to energy band diagrams described below.

As illustrated in Fig. 2, among the two semiconductor materials included in the photoelectric conversion layer 4, a material whose energy level of LUMO is shallower, that is, the electron affinity is smaller, is a donor semiconductor material 4A that is a donor material. Among the two semiconductor materials included in the photoelectric conversion layer 4, a material whose energy level of LUMO is deeper, that is, the electron affinity is greater, is an acceptor semiconductor material 4B that is an acceptor material. In Fig. 2, the energy band of the donor semiconductor material 4A and the energy band of the acceptor semiconductor material 4B are illustrated to be displaced in the horizontal direction. However, this is for viewability, and does not mean that the donor semiconductor material 4A and the acceptor semiconductor material 4B are distributed separately in the thickness direction of the photoelectric conversion layer 4. The energy band of the acceptor semiconductor material 4B is represented by a broken-line rectangle. However, this is also for viewability, and it is not intended to discriminate a broken-line rectangle from a solid-line rectangle. The same applies to energy band diagrams described below.

The ionization potential of the donor semiconductor material 4A is, for example, less than the ionization potential of the acceptor semiconductor material 4B.

In Fig. 2, the electron affinity and the ionization potential of the charge blocking layer 3 are, for example, the electron affinity and the ionization potential of the first semiconductor material included in the charge blocking layer 3.

The charge blocking layer 3 is configured to transport signal charges and to block charges whose polarity is opposite to that of signal charges. As illustrated in Fig. 2, when holes are used as signal charges, the electron affinity of the charge blocking layer 3 is, for example, less than or equal to the electron affinity of the acceptor semiconductor material 4B of the photoelectric conversion layer 4. Moreover, the electron affinity of the charge blocking layer 3 is less than the work function of the lower electrode 2. Thus, the charge blocking layer 3 suppresses injection of charges (to be specific, electrons) whose polarity is opposite to that of signal charges from the lower electrode 2 to the photoelectric conversion layer 4. As a result, it is possible to reduce noise signals due to dark current, which negatively influence the S/N ratio (signal-to-noise ratio). When the charge blocking layer 3 has a structure in which layers are stacked, the electron affinity of at least one of the layers is less than or equal to the electron affinity of the acceptor semiconductor material 4B of the photoelectric conversion layer 4 and is less than the work function of the lower electrode 2.

For example, the difference between the ionization potential of the charge blocking layer 3 and the ionization potential of the donor semiconductor material 4A of the photoelectric conversion layer 4 is less than or equal to 1 eV. Thus, signal charges can be easily transported in the charge blocking layer 3, and the efficiency of the lower electrode 2 in extracting signal charges generated by the photoelectric conversion layer 4 improves. When the charge blocking layer 3 has a structure in which layers are stacked, for example, the difference between the ionization potential of any of the layers and the ionization potential of the donor semiconductor material 4A is less than or equal to 1 eV.

When electrons are used as signal charges, in order to suppress injection of holes from the lower electrode 2 to the photoelectric conversion layer 4, the ionization potential of the charge blocking layer 3 is, for example, greater than or equal to the ionization potential of the donor semiconductor material 4A of the photoelectric conversion layer 4. When electrons are used as signal charges, the ionization potential of the charge blocking layer 3 is greater than the work function of the lower electrode 2.

When electrons are used as signal charges, the difference between the electron affinity of the charge blocking layer 3 and the electron affinity of the acceptor semiconductor material 4B is less than or equal to 1 eV. Thus, the efficiency of the lower electrode 2 in extracting signal charges (to be specific, electrons) improves.

[Another Example of Photoelectric Conversion Element]

A photoelectric conversion element according to the present embodiment may further includes a charge blocking layer also between the upper electrode 5 and the photoelectric conversion layer 4. Fig. 3 is a schematic sectional view illustrating the configuration of another photoelectric conversion element 11 according to the present embodiment. As illustrated in Fig. 3, the photoelectric conversion element 11 further includes, in addition to the configuration of the photoelectric conversion element 10, a charge blocking layer 6 between the upper electrode 5 and the photoelectric conversion layer 4. The charge blocking layer 6 is, for example, in contact with the upper electrode 5 and the photoelectric conversion layer 4. The charge blocking layer 6 is an example of a second charge blocking layer.

The charge blocking layer 6 includes, for example, a second semiconductor material. The second semiconductor material is, for example, an organic semiconductor material. The organic semiconductor material is, for example, the aforementioned donor organic semiconductor material or acceptor organic semiconductor material. The second semiconductor material of the charge blocking layer 6 is not limited to an organic semiconductor material, may be an oxide semiconductor, a nitride semiconductor, or the like, or may be a composite material of these. The material of the charge blocking layer 6 may be, for example, a metal oxide such as aluminum oxide. The charge blocking layer 6 may include the same material as the charge blocking layer 3. The charge blocking layer 6 may include a material that is the same as a donor semiconductor material included in the photoelectric conversion layer 4.

The charge blocking layer 6 may have a structure in which layers are stacked. In this case, the materials of the layers may be the same, or may be different from each other.

The charge blocking layer 6 is configured to transport charges whose polarity is opposite to that of signal charges and to block signal charges. When holes are used as signal charges, the ionization potential of the charge blocking layer 6 is, for example, greater than or equal to the ionization potential of the donor semiconductor material 4A of the photoelectric conversion layer 4. The ionization potential of the charge blocking layer 6 is greater than the work function of the upper electrode 5. Thus, the charge blocking layer 6 suppresses injection of signal charges (to be specific, holes) from the upper electrode 5 to the photoelectric conversion layer 4. As a result, it is possible to reduce noise signals due to dark current, which negatively influence the S/N ratio. When the charge blocking layer 6 has a structure in which layers are stacked, the ionization potential of at least one of the layers is greater than or equal to the ionization potential of the donor semiconductor material 4A of the photoelectric conversion layer 4 and is greater than the work function of the upper electrode 5.

For example, the difference between the electron affinity of the charge blocking layer 6 and the electron affinity of the acceptor semiconductor material 4B of the photoelectric conversion layer 4 is less than or equal to 1 eV. Thus, the efficiency in transporting charges (to be specific, electrons) whose polarity is opposite to that of signal charges to the upper electrode 5 improves. When the charge blocking layer 6 has a structure in which layers are stacked, for example, the difference between the electron affinity of any of the layers and the electron affinity of the acceptor semiconductor material 4B is less than or equal to 1 eV.

The electron affinity and the ionization potential of the charge blocking layer 6 are, for example, the electron affinity and the ionization potential of the second semiconductor material included in the charge blocking layer 6.

The thickness of the charge blocking layer 6 is, for example, greater than or equal to 5 nm. In view of effective suppression of dark current and noise, the thickness of the charge blocking layer 6 may be greater than or equal to 10 nm, may be greater than or equal to 20 nm, or may be greater than or equal to 30 nm. In view of suppression of decrease of sensitivity, the thickness of the charge blocking layer 6 may be less than or equal to 500 nm or may be less than or equal to 300 nm.

When electrons are used as signal charges, in order to suppress injection of electrons from the upper electrode 5 to the photoelectric conversion layer 4, the electron affinity of the charge blocking layer 6 is, for example, less than or equal to the electron affinity of the acceptor semiconductor material 4B of the photoelectric conversion layer 4. When electrons are used as signal charges, the electron affinity of the charge blocking layer 6 is less than the work function of the upper electrode 5.

When electrons are used as signal charges, the difference between the ionization potential of the charge blocking layer 6 and the ionization potential of the donor semiconductor material 4A is less than or equal to 1 eV. Thus, the efficiency in movement of charges (to be specific, holes) whose polarity is opposite to that of signal charges to the upper electrode 5 improves.

[Imaging Device]

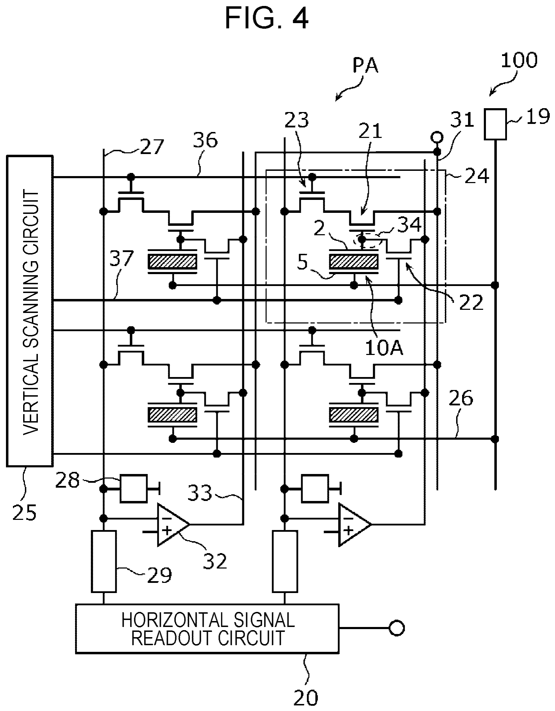

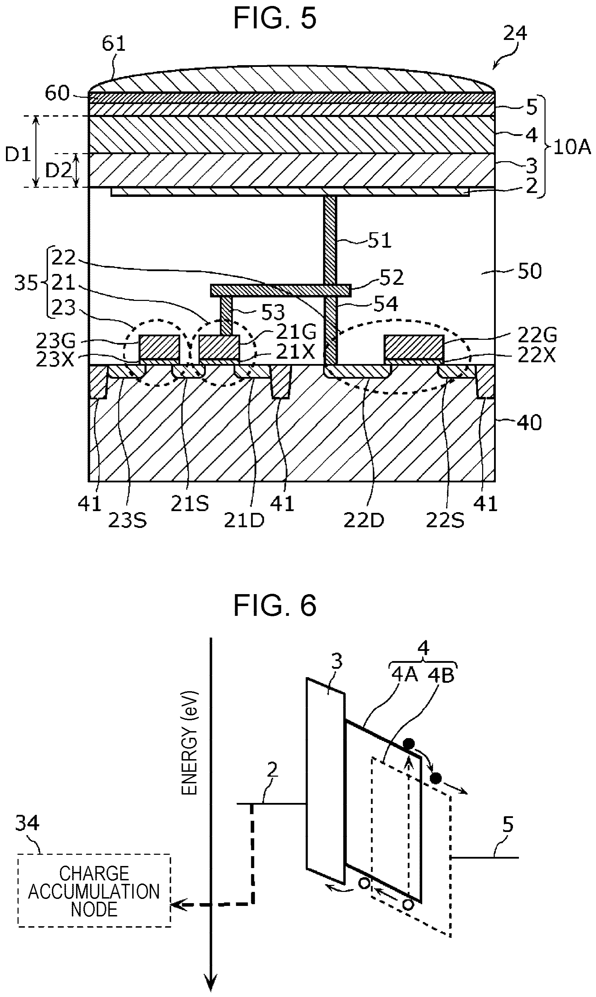

Next, referring to Figs. 4 and 5, an imaging device according to the present embodiment will be described. Fig. 4 illustrates an example of the circuit configuration of an imaging device 100 including a photoelectric converter 10A using the photoelectric conversion element 10 illustrated in Fig. 1. Fig. 5 is a schematic sectional view illustrating the device structure of a pixel 24 of the imaging device 100 according to the present embodiment.

As illustrated in Figs. 4 and 5, the imaging device 100 according to the present embodiment includes: a semiconductor substrate 40; and pixels 24 each including a charge detection circuit 35 provided at the semiconductor substrate 40, the photoelectric converter 10A provided above the semiconductor substrate 40, and a charge accumulation node 34 electrically connected to the charge detection circuit 35 and the photoelectric converter 10A. The photoelectric converter 10A of each pixel 24 includes the aforementioned photoelectric conversion element 10. That is, each pixel 24 includes the lower electrode 2, the upper electrode 5, the photoelectric conversion layer 4, and the charge blocking layer 3. In the present embodiment, the charge accumulation node 34 is an example of a charge accumulation region. The photoelectric converter 10A may include the photoelectric conversion element 11. That is, each pixel 24 may further include the charge blocking layer 6 in addition to the configuration described above.

In the photoelectric converter 10A, the upper electrode 5, the photoelectric conversion layer 4, the charge blocking layer 3, and the lower electrode 2 are arranged in this order from the side from which light enters the imaging device 100. In the present embodiment, light that has passed through the upper electrode 5 enters the photoelectric conversion layer 4. In the present embodiment, the side from which light enters the imaging device 100 is opposite from the semiconductor substrate 40 side of the photoelectric converter 10A. In the present embodiment, the side from which light enters is the upper side.

The charge accumulation node 34 accumulates signal charges generated by the photoelectric converter 10A, and the charge detection circuit 35 detects signal charges accumulated in the charge accumulation node 34. The charge detection circuit 35, which is provided at the semiconductor substrate 40, may be provided on the semiconductor substrate 40, or may be directly provided in the semiconductor substrate 40.

As illustrated in Fig. 4, the imaging device 100 includes the pixels 24 and peripheral circuits. The imaging device 100 is, for example, an image sensor implemented in a one-chip integrated circuit, and includes a pixel array PA including the pixels 24 that are arranged two-dimensionally.

The pixels 24 are arranged on the semiconductor substrate 40 two-dimensionally, that is, in the row direction and the column direction, to form a photosensitive region that is a pixel region. Fig. 4 illustrates an example in which the pixels 24 are arranged in a 2×2 matrix pattern. The arrangement of the pixels 24 is not limited to 2×2, and the number of rows and the number of columns of the pixels 24 are not particularly limited. In Fig.

4, for convenience of illustration, illustration of a circuit (for example, a pixel electrode control circuit) for individually setting the sensitivities of the pixels 24 is omitted. The imaging device 100 may be a line sensor. In this case, the pixels 24 may be arranged one-dimensionally. In the present specification, the term "row direction" and the term "column direction" respectively refer to a direction in which rows extend and a direction in which columns extend. That is, in Fig. 4, the vertical direction in the plane of the figure is the column direction, and the horizontal direction in the plane of the figure is the row direction.

As illustrated in Figs. 4 and 5, each pixel 24 includes the photoelectric converter 10A, the charge detection circuit 35, and the charge accumulation node 34 electrically connected to the photoelectric converter 10A and the charge detection circuit 35. The charge detection circuit 35 includes an amplification transistor 21, a reset transistor 22, and an address transistor 23.

The photoelectric converter 10A includes the lower electrode 2, which is provided as a pixel electrode, and the upper electrode 5, which is provided as a counter electrode that faces the pixel electrode. It is not necessary that the entirety of the photoelectric converter 10A be an element that is independent for each pixel 24, and a part of the photoelectric converter 10A may be shared by two or more pixels 24. A voltage for applying a predetermined bias voltage is supplied to the upper electrode 5 via a counter electrode signal line 26.

The lower electrode 2 is connected to a gate electrode 21G of the amplification transistor 21, and signal charges collected by the lower electrode 2 are accumulated in the charge accumulation node 34 positioned between the lower electrode 2 and the gate electrode 21G of the amplification transistor 21. For example, when signal charges are holes, the charge accumulation node 34 is electrically connected to the lower electrode 2 and accumulates holes, among the excitons generated by the photoelectric conversion layer 4.

A voltage in accordance with the quantity of signal charges accumulated in the charge accumulation node 34 is applied to the gate electrode 21G of the amplification transistor 21. The amplification transistor 21 amplifies the voltage, and the address transistor 23 selectively reads out the voltage as a signal voltage. The reset transistor 22 has a source/drain electrode connected to the lower electrode 2 via the charge accumulation node 34, and resets signal charges accumulated in the charge accumulation node 34. In other words, the reset transistor 22 resets the potential of the gate electrode 21G of the amplification transistor 21 and the lower electrode 2.

In order to selectively perform the above operation in the pixels 24, the imaging device 100 includes a power source wiring line 31, a vertical signal line 27, an address signal line 36, and a reset signal line 37. These lines are connected to each pixel 24. To be specific, the power source wiring line 31 is connected to the source/-

drain electrode of the amplification transistor 21, and the vertical signal line 27 is connected to the source/drain electrode of the address transistor 23. The address signal line 36 is connected to a gate electrode 23G of the address transistor 23. The reset signal line 37 is connected to a gate electrode 22G of the reset transistor 22.

The peripheral circuits include a voltage supply circuit 19, a vertical scanning circuit 25, a horizontal signal readout circuit 20, column signal processing circuits 29, load circuits 28, and differential amplifiers 32.

The voltage supply circuit 19 is electrically connected to the upper electrode 5 via the counter electrode signal line 26. By applying a voltage to the upper electrode 5, the voltage supply circuit 19 provides a potential difference between the upper electrode 5 and the lower electrode 2, that is, applies a voltage between the upper electrode 5 and the lower electrode 2. When the lower electrode 2 collects holes as signal charges, the voltage supply circuit 19 supplies, to the upper electrode 5, a voltage such that the potential of the upper electrode 5 becomes higher than the potential of the lower electrode 2. When the lower electrode 2 collects electrons as signal charges, the voltage supply circuit 19 supplies, to the upper electrode 5, a voltage such that the potential of the upper electrode 5 becomes lower than the potential of the lower electrode 2.

As described below in detail, the sensitivity of the photoelectric converter 10A is controlled by switching a voltage supplied from the voltage supply circuit 19 to the upper electrode 5 between voltages that are different from each other.

For example, the voltage supply circuit 19 selectively applies, between the lower electrode 2 and the upper electrode 5, a bias voltage such that the potential of the upper electrode 5 relative to the lower electrode 2 becomes a positive potential and a bias voltage such that the potential of the upper electrode 5 relative to the lower electrode 2 becomes a negative potential.

The voltage supply circuit 19 is not limited to a specific power source circuit, may be a circuit that generates a predetermined voltage, or may be a circuit that changes a voltage supplied from another power source to a predetermined voltage. The imaging device 100 need not include the voltage supply circuit 19. For example, a voltage may be supplied to the upper electrode 5 from an external power source.

The vertical scanning circuit 25 is connected to the address signal line 36 and the reset signal line 37, selects pixels 24 disposed in each row on a row-by-row basis, and performs readout of a signal voltage and resetting of the potential of the lower electrode 2. The power source wiring line 31, which is a source follower power source, supplies a predetermined power source voltage to each pixel 24. The horizontal signal readout circuit 20 is electrically connected to the column signal processing circuits 29. The column signal processing circuit 29 is electrically connected to the pixels 24 that are disposed in each column via the vertical signal line 27 corresponding to each column. The load circuit 28 is electrically connected to each vertical signal line 27. The load circuit 28 and the amplification transistor 21 form a source follower circuit.

The differential amplifiers 32 are provided to correspond to each column. An inverting input terminal of the differential amplifier 32 is connected to a corresponding vertical signal line 27. An output terminal of the differential amplifier 32 is connected to the pixel 24 via a feedback line 33 corresponding to each column.

The vertical scanning circuit 25 applies, via the address signal line 36, a row selection signal for controlling on and off of the address transistor 23 to the gate electrode 23G of the address transistor 23. Thus, a row to be read out is scanned and selected. A signal voltage is read out to the vertical signal line 27 from the pixel 24 in the selected row. The vertical scanning circuit 25 applies, via the reset signal line 37, a reset signal for controlling on and off of the reset transistor 22 to the gate electrode 22G of the reset transistor 22. Thus, a row of the pixel 24 to be reset is selected. The vertical signal line 27 transmits, to the column signal processing circuits 29, a signal voltage that has been read out from the pixel 24 selected by the vertical scanning circuit 25.

The column signal processing circuit 29 performs noise-reduction signal processing, which is typified by correlated double sampling, analog-to-digital conversion (AD conversion), and the like.

The horizontal signal readout circuit 20 sequentially reads out signals from the column signal processing circuits 29 to a horizontal common signal line.

The differential amplifier 32 is connected to the drain electrode of the reset transistor 22 via the feedback line 33. Accordingly, the differential amplifier 32 receives an output value of the address transistor 23 at the inverting input terminal. The differential amplifier 32 performs a feedback operation so that the gate potential of the amplification transistor 21 becomes a predetermined feedback voltage. At this time, the output voltage value of the differential amplifier 32 is, for example, 0 V or a positive voltage near 0 V. The term "feedback voltage" means the output voltage of the differential amplifier 32.

As illustrated in Fig. 5, the pixel 24 includes the semiconductor substrate 40, the charge detection circuit 35, the photoelectric converter 10A, and the charge accumulation node 34 (see Fig. 4).

The semiconductor substrate 40 may be an insulating substrate on which a semiconductor layer is provided on a surface thereof on a side on which a photosensitive region is formed, and may be, for example, a p-type silicon substrate. The semiconductor substrate 40 has impurity regions 21D, 21S, 22D, 22S, and 23S, and an element separation region 41 for electrical separation between the pixels 24. The impurity regions 21D, 21S, 22D, 22S, and 23S are, for example, n-type regions. Here, the element separation region 41 is provided between the impurity region 21D and the impurity region 22D. Thus, leakage of signal charges accumulated in the charge accumulation node 34 is suppressed. The element separation region 41 is formed, for example, by performing ion injection of an acceptor under a predetermined injection condition.

The impurity regions 21D, 21S, 22D, 22S, and 23S are, for example, dispersion regions formed in the semiconductor substrate 40. As illustrated in Fig. 5, the amplification transistor 21 includes the impurity region 21S, the impurity region 21D, and the gate electrode 21G. The impurity region 21S and the impurity region 21D respectively function as, for example, a source region and a drain region of the amplification transistor 21. A channel region of the amplification transistor 21 is formed between the impurity region 21S and the impurity region 21D.

Likewise, the address transistor 23 includes the impurity region 23S, the impurity region 21S, and the gate electrode 23G connected to the address signal line 36. In this example, the amplification transistor 21 and the address transistor 23 are electrically connected to each other by sharing the impurity region 21S. The impurity region 23S functions as, for example, a source region of the address transistor 23. The impurity region 23S has connection with the vertical signal line 27 illustrated in Fig. 4.

On the semiconductor substrate 40, an interlayer insulating layer 50 is stacked in such a way as to cover the amplification transistor 21, the address transistor 23, and the reset transistor 22. In Fig. 5, hatching that indicates the cross section of the interlayer insulating layer 50 is omitted for viewability.

A wiring layer (not shown) can be disposed in the interlayer insulating layer 50. The wiring layer is made from, for example, a metal such as copper, and can include, for example, wiring such as the aforementioned vertical signal line 27 in a part thereof. It is possible to set the number of insulating layers in the interlayer insulating layer 50 and the number of layers included in a wiring layer disposed in the interlayer insulating layer 50 to any appropriate number.

In the interlayer insulating layer 50, a contact plug 53 connected to the gate electrode 21G of the amplification transistor 21; a contact plug 54 connected to the impurity region 22D of the reset transistor 22; a contact plug 51 connected to the lower electrode 2; and wiring 52 that connects the contact plug 51, the contact plug 54, and the contact plug 53 are disposed. Thus, the impurity region 22D of the reset transistor 22 is electrically connected to the gate electrode 21G of the amplification transistor 21. In the configuration illustrated in Fig. 5, the contact plugs 51, 53, and 54, the wiring 52, the gate electrode 21G of the amplification transistor 21, and the impurity region 22D of the reset transistor 22 constitute at least a part of the charge accumulation node 34.

The charge detection circuit 35 detects signal charges collected by the lower electrode 2, and outputs a signal voltage. The charge detection circuit 35 includes the amplification transistor 21, the reset transistor 22, and the address transistor 23, and is formed in the semiconductor substrate 40.

The amplification transistor 21 is formed in the semiconductor substrate 40; and includes the impurity region 21D and the impurity region 21S that respectively function as a drain electrode and a source electrode, a gate insulating layer 21X formed on the semiconductor substrate 40, and the gate electrode 21G formed on the gate insulating layer 21X.

The reset transistor 22 is formed in the semiconductor substrate 40; and includes the impurity region 22D and the impurity region 22S that respectively function as a drain electrode and a source electrode, a gate insulating layer 22X formed on the semiconductor substrate 40, and the gate electrode 22G formed on the gate insulating layer 22X.

The address transistor 23 is formed in the semiconductor substrate 40; and includes the impurity regions 21S and 23S that respectively function as a drain electrode and a source electrode, a gate insulating layer 23X formed on the semiconductor substrate 40, and the gate electrode 23G formed on the gate insulating layer 23X. Through the impurity region 21S, the amplification transistor 21 and the address transistor 23 are connected in series.

The aforementioned photoelectric converter 10A is disposed on the interlayer insulating layer 50. In other words, in the present embodiment, the pixels 24 of the pixel array PA are formed on the semiconductor substrate 40. The pixels 24, which are arranged two-dimensionally on the semiconductor substrate 40, form a photosensitive region. The distance between two pixels 24 that are connected (that is, the pixel pitch) may be, for example, about 2 μm.

The charge blocking layer 3, the photoelectric conversion layer 4, and the upper electrode 5 are formed, for example, across multiple pixels 24. On the other hand, the lower electrode 2 is provided in each pixel 24, and is electrically separated from the lower electrode 2 of an adjacent pixel 24 by being spatially separated from the lower electrode 2 of the adjacent pixel 24. As described above, the upper electrode 5 has connection with the counter electrode signal line 26 connected to the voltage supply circuit 19. Accordingly, it is possible to simultaneously apply a voltage of a desirable magnitude between multiple pixels 24 from the voltage supply circuit 19 via the counter electrode signal line 26. As long as it is possible to apply a voltage of a desirable magnitude from the voltage supply circuit 19, the upper electrode 5 may be separately provided in each pixel 24. Likewise, the photoelectric conversion layer 4 and the charge blocking layer 3 may be separately provided in each pixel 24.

The shortest distance D1 between the lower electrode 2 and the upper electrode 5 and the thickness D2 of the charge blocking layer 3 in the photoelectric converter 10A will be described below. As illustrated in Fig. 5, the shortest distance D1 between the lower electrode 2 and the upper electrode 5 is also the total thickness of layers disposed between the lower electrode 2 and the upper electrode 5 (in the example illustrated in Fig. 5, the total thickness of the charge blocking layer 3 and the photoelectric conversion layer 4). The thickness D2 of the charge blocking layer 3 is also the shortest distance between the lower electrode 2 and the photoelectric conversion layer 4.

A color filter 60 is formed above the photoelectric converter 10A, and a microlens 61 is formed above the color filter 60. The color filter 60 is formed, for example, as an on-chip color filter by patterning, and a photosensitive resin or the like in which a dye or a pigment is dispersed is used as the material of the color filter 60. The microlens 61 is formed, for example, as an on-chip microlens, and an ultraviolet sensitive material or the like is used as the material of the microlens 61.

It is possible to use a general semiconductor manufacturing process to manufacture the imaging device 100. In particular, when a silicon substrate is to be used as the semiconductor substrate 40, it is possible to manufacture the imaging device 100 by using various silicon semiconductor processes.

[Operation of Imaging Device]

The imaging device 100 operates, for example, by using a global shutter method in which the exposure periods of the pixels 24 are uniform. In the present specification, the term "exposure period" means a period for accumulating either electrons or holes generated by photoelectric conversion as signal charges in the charge accumulation node 34. In the present specification, the term "non-exposure period" refers to a period when the imaging device 100 is operating and that is not the exposure period. The "non-exposure period" may be a period when entry of light into the photoelectric converter 10A is blocked, or may be a period when the photoelectric converter 10A is irradiated with light but charges are not practically accumulated in the charge accumulation node 34. A readout operation of the imaging device 100 is not limited to an operation using a global shutter method, and any readout operation of known imaging devices can be used. For example, the imaging device 100 may operate by using a rolling shutter method with which signals are read out by exposing the pixels 24 to light sequentially from pixel column to pixel column.

For example, the voltage supply circuit 19 supplies, to the upper electrode 5, a voltage for performing imaging with desirable sensitivity in the exposure period, and supplies, to the upper electrode 5, a voltage such that the photoelectric converter 10A does not have sensitivity in the non-exposure period. Therefore, the photoelectric conversion efficiency of the pixels 24 in the exposure period is different from the photoelectric conversion efficiency of the pixels 24 in the non-exposure period, and, to be specific, is higher than the photoelectric conversion efficiency of the pixels 24 in the non-exposure period. In the exposure period, signal charges are accumulated in the charge accumulation node 34. In the non-exposure period, an operation of reading out signal charges accumulated in the charge accumulation node 34 in the exposure period is sequentially performed from pixel column to pixel column. The expression "the photoelectric converter 10A does not have sensitivity" means that the photoelectric converter 10A does not practically have sensitivity. For example, the sensitivity of the photoelectric converter 10A in the non-exposure period is less than or equal to 5% of the sensitivity of the photoelectric converter 10A in the exposure period. The sensitivity of the photoelectric converter 10A in the non-exposure period may be less than equal to 1% of the sensitivity of the photoelectric converter 10A in the exposure period.

For example, in a first period that is an exposure period, the voltage supply circuit 19 supplies, to the upper electrode 5, a voltage such that a first bias voltage is applied between the lower electrode 2 and the upper electrode 5. For example, in a second period that is a non-exposure period, the voltage supply circuit 19 supplies, to the upper electrode 5, a voltage such that a second bias voltage is applied between the lower electrode 2 and the upper electrode 5. The photoelectric conversion layer 4 of the photoelectric converter 10A has photoelectric conversion sensitivity when the first bias voltage is applied between the lower electrode 2 and the upper electrode 5. Electrons and holes in the photoelectric conversion layer 4 recombine when the second bias voltage is applied between the lower electrode 2 and the upper electrode 5. The absolute value of the second bias voltage is, for example, less than the absolute value of the first bias voltage. The magnitude of a bias voltage applied between the lower electrode 2 and the upper electrode 5 changes also depending on the potential of the charge accumulation node 34, that is, the quantity of accumulated signal charges. The voltage supply circuit 19 selectively applies to the upper electrode 5, for example, a voltage such that the potential difference between the potential of the upper electrode 5 and the potential of the lower electrode 2 when the pixel 24 is reset becomes the first bias voltage and the second bias voltage. That is, in the present specification, the expression "the first bias voltage or the second bias voltage is applied between the lower electrode 2 and the upper electrode 5" means that a voltage such that the potential difference between the potential of the upper electrode 5 and the potential of the lower electrode 2 when the pixel 24 is reset becomes the first bias voltage or the second bias voltage is supplied to the upper electrode 5.

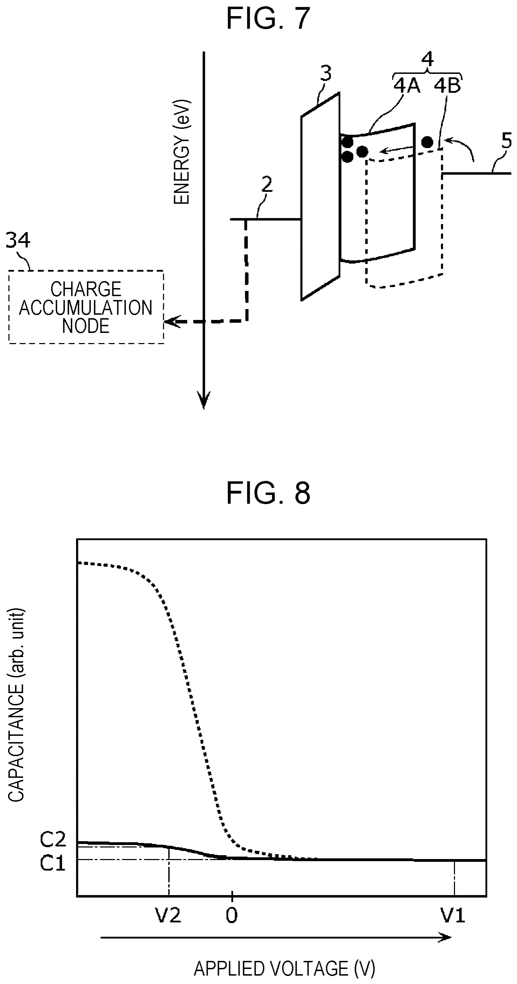

Fig. 6 is an exemplary energy band diagram of the photoelectric converter 10A when the first bias voltage is applied between the lower electrode 2 and the upper electrode 5. Fig. 7 is an exemplary energy band diagram of the photoelectric converter 10A when the second bias voltage is applied between the lower electrode 2 and the upper electrode 5. In Figs. 6 and 7, energy bands when the photoelectric converter 10A includes the photoelectric conversion element 10 is illustrated. In Figs. 6 and 7, electrons are indicated by black circles, holes are indicated by white circles, and some of the movements of electrons and holes are schematically illustrated.

For example, when the imaging device 100 accumulates holes in the charge accumulation node 34 as signal charges in an exposure period, as illustrated in Fig. 6, a first bias voltage with which the potential of the upper electrode 5 relative to the potential of the lower electrode 2 becomes a positive potential is applied between the lower electrode 2 and the upper electrode 5. Then, in the state illustrated in Fig. 6, pairs of electrons and holes are generated in the photoelectric conversion layer 4. Subsequently, because a potential higher than the potential of the lower electrode 2 is applied to the upper electrode 5, holes move to the lower electrode 2, electrons move to the upper electrode 5, and holes are accumulated in the charge accumulation node 34. That is, in the exposure period, signal charges in a quantity in accordance with the intensity of light with which the photoelectric converter 10A is irradiated are accumulated in the charge accumulation node 34.

In the state illustrated in Fig. 6, because holes move from the photoelectric conversion layer 4 to the lower electrode 2 through the charge blocking layer 3 and electrons move from the photoelectric conversion layer 4 to the upper electrode 5, the quantity of charges accumulated in the photoelectric converter 10A is small.

For example, when the imaging device 100 reads out signal charges in a non-exposure period after the aforementioned exposure period, as illustrated in Fig. 7, a second bias voltage with which the potential of the upper electrode 5 relative to the potential to the lower electrode 2 becomes a negative voltage is applied between the lower electrode 2 and the upper electrode 5. Then, in the state illustrated in Fig. 7, holes accumulated in the charge accumulation node 34 via the lower electrode 2 are read out. In the non-exposure period, the second bias voltage for suppressing movement of charges in the photoelectric converter 10A is applied between the lower electrode 2 and the upper electrode 5. Therefore, in a state in which the second bias voltage is applied, holes accumulated in the charge accumulation node 34 are not easily discharged to the lower electrode 2 and charges supplied from the voltage supply circuit 19 via the lower electrode 2 do not easily flow into the charge accumulation node 34. Therefore, in the non-exposure period, even when a readout operation is performed sequentially from row to row, the quantity of charges accumulated in the charge accumulation node 34 does not easily fluctuate during the readout operation.

In the state illustrated in Fig. 7, because a voltage lower than the potential of the lower electrode 2 is applied to the upper electrode 5, electrons generated in the photoelectric conversion layer 4 and remaining in the photoelectric conversion layer 4 or electrons injected from the upper electrode 5 accumulate near the interface between the photoelectric conversion layer 4 and the charge blocking layer 3. Moreover, in a non-exposure period, because a second bias voltage for suppressing movement of charges is applied between the lower electrode 2 and the upper electrode 5, the quantity of charges accumulated in the photoelectric converter 10A is larger than that in an exposure period.

In a non-exposure period, the quantity of accumulated electrons depends on the thickness D2 of the charge blocking layer 3. To be specific, as accumulation of electrons progresses, as illustrated in Fig. 7, the energy band of the photoelectric conversion layer 4 near the interface between the photoelectric conversion layer 4 and the charge blocking layer 3 becomes curved. Because an electric field acting near the interface between the photoelectric conversion layer 4 and the charge blocking layer 3 weakens, accumulation of electrons in the photoelectric conversion layer 4 becomes constant. It is possible to regard each pixel in this state as a capacitor having the charge blocking layer 3 as a dielectric, and the quantity of accumulated electrons becomes equal to the quantity of charges accumulated in the capacitor. Thus, when the thickness D2 of the charge blocking layer 3 corresponding to the dielectric is increased, the quantity of accumulated electrons decreases. Moreover, variation in the quantity of charges accumulated in the photoelectric converter 10A when the first bias voltage is applied and when the second bias voltage is applied depends on the ratio of the thickness D2 of the charge blocking layer 3 to the shortest distance D1 between the upper electrode 5 and the lower electrode 2.

[Capacitance-Voltage Characteristics of Photoelectric Converter]

Next, the capacitance-voltage characteristics of the photoelectric converter 10A will be described.

Fig. 8 is a graph schematically illustrating an example of the capacitance-voltage characteristics (C-V characteristics) of the photoelectric converter 10A according to the present embodiment. In Fig. 8, the vertical axis represents the capacitance between the lower electrode 2 and the upper electrode 5, and the horizontal axis represents the voltage applied between the upper electrode 5 and the lower electrode 2. Fig. 8 also schematically illustrates an example of the capacitance-voltage characteristics of a photoelectric converter according to a reference example.

In Fig. 8, the solid line illustrates an example of the C-V characteristics of the photoelectric converter 10A according to the present embodiment. The broken line illustrates an example of the C-V characteristics of the photoelectric converter according to the reference example. The C-V characteristics illustrated in Fig. 8 are measured, for example, in a state in which the photoelectric converter 10A is not irradiated with light. In Fig. 8, capacitance is represented in an arbitrary unit that is normalized.

In Fig. 8, the C-V characteristics are illustrated based on the definition that a voltage such that signal charges move to the lower electrode 2 has a "positive" value. That is, in Fig. 8, a voltage such that signal charges are collected by the lower electrode 2 is on the right side of the horizontal axis, and a voltage such that movement of signal charges to the lower electrode 2 is suppressed is on the left side of the horizontal axis. Therefore, when signal charges are holes, a voltage such that the potential of the upper electrode 5 becomes higher than the potential of the lower electrode 2 has a "positive" value. When signal charges are electrons, a voltage such that the potential of the upper electrode 5 becomes lower than the potential of the lower electrode 2 has a "positive" value. As illustrated in Fig. 8, a first bias voltages V1 for causing signal charges to be collected by the lower electrode 2 is higher than a second bias voltage V2 for suppressing movement of signal charges to the lower electrode 2 and prompting recombination of holes with electrons.

As illustrated in Fig. 8, in the C-V characteristics of the photoelectric converter according to the reference example and the photoelectric converter 10A according to the present embodiment, generally, the capacitance increases as the voltage applied between the lower electrode 2 and the upper electrode 5 is reduced. To be more specific, in the C-V characteristics of the photoelectric converter 10A, as the voltage applied between the lower electrode 2 and the upper electrode 5 is reduced from a positive high voltage, the capacitance stays constant before the voltage becomes a predetermined voltage, and the capacitance increases after the voltage becomes lower than the predetermined voltage. This is because it becomes easier for charges to be accumulated in the photoelectric converter 10A as described above. As the voltage is reduced further from the predetermined voltage, the capacitance becomes constant again when the voltage becomes lower than equal to a predetermined negative voltage. The expression "the capacitance becomes constant" means that change in capacitance when voltage changes by 1 V is less than or equal to 1% when the voltage is reduced or increased within a range such that the photoelectric converter 10A does not break. In the C-V characteristics of the photoelectric converter 10A, when the voltage is reduced further than the predetermined negative voltage, the potential difference between the lower electrode 2 and the upper electrode 5 increases and it may become easier for charges accumulated in the photoelectric converter 10A to move to the electrode again, and thus the capacitance that has once increased may decrease.

The capacitance C1 is less than the capacitance C2, where C1 is the capacitance when the first bias voltage V1 is applied between the lower electrode 2 and the upper electrode 5, and C2 is the capacitance when the second bias voltage V2 is applied between the lower electrode 2 and the upper electrode 5. This is because, as described above with reference to Figs. 6 and 7, the quantity of charges accumulated in the photoelectric converter 10A is small when the first bias voltage V1 is applied and the quantity of charges accumulated in the photoelectric converter 10A is large when the second bias voltage V2 is applied. The capacitances C1 and C2 are each the average value of capacitances that are obtained by measuring impedances at alternating-current frequencies from 10 Hz to 10 kHz by using an impedance measuring device such as an LCR meter connected to the lower electrode 2 and the upper electrode 5 in a state in which the photoelectric converter 10A is not irradiated with light. The capacitance C1 and C2 are each measured, for example, collectively for multiple pixels 24 and calculated as a value in the photoelectric converter 10A of one pixel 24. The capacitance C1 and C2 each may be measured, by dividing the imaging device 100, for pixel blocks each including one pixel 24 or two or more pixels 24.

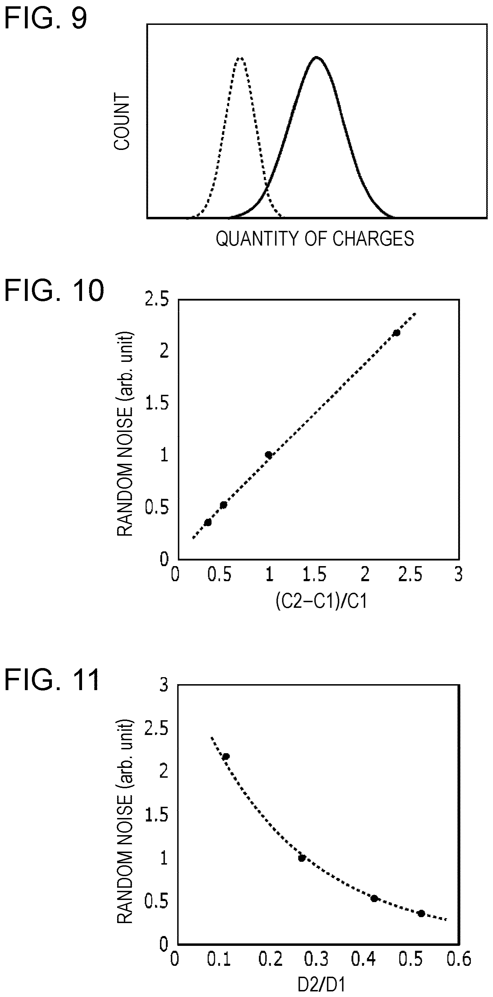

Fig. 9 is a graph conceptually illustrating the distribution of the quantity of charges accumulated in the photoelectric converter 10A. In Fig. 9, the horizontal axis represents the quantity of charges accumulated in the photoelectric converter 10A. In Fig. 9, the vertical axis represents one of the followings: the number of photoelectric converters 10A in which charges in the quantity represented by the horizontal axis are accumulated when the charges are accumulated in the photoelectric converters 10A under the same conditions; and the number of times charges in the quantity represented by the horizontal axis are accumulated in the photoelectric converter 10A when charges are accumulated in the photoelectric converter 10A multiple times at regular intervals under the same conditions.

In Fig. 9, the solid line exemplarily illustrates the distribution when the quantity of charges accumulated in the photoelectric converter 10A is large. In Fig. 9, the broken line exemplarily illustrates the distribution when the quantity of charges accumulated in the photoelectric converter 10A is small. As illustrated in Fig. 9, the dispersion of the quantity of charges accumulated in the photoelectric converter 10A changes depending on the quantity of charges. Therefore, when variation in the quantity of charges accumulated in the photoelectric converter 10A in an exposure period and a non-exposure period is small, the quantity of charges accumulated in the photoelectric converter 10A is small even in the non-exposure period, when charges tend to accumulate in the photoelectric converter 10A, and dispersion of the quantity of charges accumulated in the photoelectric converter 10A decreases. Thus, it is possible to reduce the influence of the quantity of charges accumulated in the photoelectric converter 10A on the charge accumulation node 34 electrically connected to the photoelectric converter 10A, and noise in the imaging device 100 can be reduced.

Because the quantity of charges in the photoelectric converter 10A depends on the capacitance of the photoelectric converter 10A, if the capacitance C1 when the first bias voltage V1 is applied and the capacitance C1 when the second bias voltage V2 is applied satisfy a predetermined condition in the photoelectric converter 10A, it is possible to realize the imaging device 100 in which noise is reduced. To be specific, in the imaging device 100 according to the present embodiment, when (C2 - C1)/C1 ≤ 1 is satisfied, it is possible to reduce the quantity of charges accumulated in the photoelectric converter 10A and to reduce noise. In view of further reduction of noise, in the imaging device 100, (C2 - C1)/C1 ≤ 0.5 may be satisfied, or (C2 - C1)/C1 ≤ 0.3 may be satisfied. In view of retention of the sensitivity of the photoelectric converter 10A, (C2 - C1)/C1 ≥ 0.1 may be satisfied.

The first bias voltage V1 is, for example, greater than 0 V, and the absolute value of the first bias voltage V1 is greater than the absolute value of the second bias voltage V2. The first bias voltage V1 may be, for example, greater than or equal to 2 V, or may be greater than or equal to 5 V. The first bias voltage V1 may be, for example, less than or equal to 15 V. The first bias voltage V1 is, for example, a voltage in a voltage range such that the capacitance becomes constant when the voltage is increased in the C-V characteristics of the photoelectric converter 10A.

The second bias voltage V2 is, for example, a negative voltage less than 0 V. The second bias voltage V2 may be less than or equal to -0.5 V, or may be less than or equal to -1 V. The second bias voltage V2 may be greater than or equal to -5 V, or may be greater than or equal to -3 V. The second bias voltage V2 is a voltage less than or equal to a voltage that forms an inflection point after the value of capacitance has started to rise when the voltage is reduced in the C-V characteristics of the photoelectric converter 10A.

These values of the first bias voltage V1 and the second bias voltage V2 are values when it is defined that a voltage such that signal charges move to the lower electrode 2 has a "positive" value as described above.

As described above, variation in the quantity of charges accumulated in the photoelectric converter 10A when the first bias voltage V1 is applied and when the second bias voltage V2 is applied depends on the ratio of the thickness D2 of the charge blocking layer 3 to the shortest distance D1 between the upper electrode 5 and the lower electrode 2. In the imaging device 100 according to the present embodiment, when the thickness D2 of the charge blocking layer 3 is greater than or equal to 25% of the shortest distance D1 between the lower electrode 2 and the upper electrode 5, it is possible to reduce the quantity of charges accumulated in the photoelectric converter 10A and to reduce noise. In view of further reduction of noise, the thickness D2 of the charge blocking layer 3 may be greater than or equal to 40% or may be greater than or equal to 50% of the shortest distance D1 between the lower electrode 2 and the upper electrode 5.

In view of suppressing decrease of the intensity of electric field applied to the photoelectric converter 10A to retain the sensitivity of the photoelectric converter 10A, the thickness D2 of the charge blocking layer 3 may be less than or equal to 80% or may be less than or equal to 60% of the shortest distance between the lower electrode 2 and the upper electrode 5.

Next, referring to Fig. 4, the saturation signal quantity and the dynamic range, which is the ratio of the saturation signal quantity to noise, of the imaging device 100 will be described. Here, a case where holes are used as signal charges will be described.

In Fig. 4, as described above, holes generated in the photoelectric converter 10A are accumulated in the charge accumulation node 34. As holes are accumulated, the potential of the charge accumulation node 34 rises. That is, in this case, the maximum potential corresponding to the quantity of charges that the charge accumulation node 34 can hold is the saturation signal quantity in the imaging device 100. In general, a voltage amplitude of about 3 V in the charge accumulation node 34, which corresponds to the gate voltage of the amplification transistor 21, is allowed. In this case, for example, when noise of 6 e$^-$ is generated in an imaging device whose conversion gain is 50 $\mu$V/e$^-$, a dynamic range of 80 dB, which is equivalent to that of human eye, can be reliably obtained. In the imaging device 100 according to the present embodiment, variation in the quantity of charges accumulated in the photoelectric converter 10A in an exposure period and a non-exposure period is small. Therefore, the quantity of charges accumulated in the photoelectric converter 10A is small even in a non-exposure period, when charges tend to accumulate in the photoelectric converter 10A, noise is reduced, and it is possible to realize a wide dynamic range.

EXAMPLES

Hereafter, an imaging device according to the present disclosure will be specifically described by using Examples. The present disclosure is not limited at all to the following Examples. To be specific, photoelectric conversion elements to be included in an imaging device according to the present disclosure and photoelectric conversion elements for characteristics comparison were made, and the capacitance was measured. In addition, imaging devices according to the present disclosure and imaging devices for characteristics comparison were made, and the noise was measured.

(Making of Photoelectric Conversion Element)

Photoelectric conversion elements according to Examples and Comparative Example were made.

[EXAMPLE 1]

TiN was used as the lower electrode 2, and the charge blocking layer 3 was formed by depositing 9,9'-[1,1'-Biphenyl]-4,4'-diylbis[3,6-bis (1,1-dimethylethyl)]-9H-carbazole on the lower electrode 2 by vacuum vapor deposition. The thickness D2 of the charge blocking layer 3 obtained at this time was 150 nm.

Next, the photoelectric conversion layer 4 was formed on the charge blocking layer 3 by vacuum-vapor co-depositing subphthalocyanine, which is a donor semiconductor material, and fullerene C60, which is an acceptor semiconductor material, as materials of the photoelectric conversion layer 4. The weight ratio of the donor semiconductor material to the acceptor semiconductor material was 1:3. The thickness of the photoelectric conversion layer 4 obtained at this time was 400 nm. As the subphthalocyanine, subphthalocyanine that had boron (B) as the central metal and in which a chloride ion was coordinated to B as a ligand was used.

Next, a photoelectric conversion element according to Example 1 was obtained by, after forming an ITO film as the upper electrode 5 on the photoelectric conversion layer 4 by sputtering, further forming an Al$_2$O$_3$ film as a sealing film on the upper electrode 5 by atomic layer deposition. In the photoelectric conversion element according to Example 1, the shortest distance D1 between the lower electrode 2 and the upper electrode 5 was 550 nm, and D2/D1 = 0.27 (27%).

[EXAMPLE 2]

Except that the charge blocking layer 3 was formed so that the thickness D2 of the charge blocking layer 3 became 300 nm, steps similar to those in Example 1 were performed, and a photoelectric conversion element according to Example 2 was obtained. In the photoelectric conversion element according to Example 2, the shortest distance D1 between the lower electrode 2 and the upper electrode 5 was 700 nm, and D2/D1 = 0.43 (43%).

[EXAMPLE 3]

Except that the charge blocking layer 3 was formed so that the thickness D2 of the charge blocking layer 3 became 450 nm, steps similar to those in Example 1 were performed, and a photoelectric conversion element according to Example 3 was obtained. In the photoelectric conversion element according to Example 3, the shortest distance D1 between the lower electrode 2 and the upper electrode 5 was 850 nm, and D2/D1 = 0.53 (53%).

[COMPARATIVE EXAMPLE 1]

Except that the charge blocking layer 3 was formed so that the thickness D2 of the charge blocking layer 3 became 50 nm, steps similar to those in Example 1 were performed, and a photoelectric conversion element according to Comparative Example 1 was obtained. In the photoelectric conversion element according to Comparative Example 1, the shortest distance D1 between the lower electrode 2 and the upper electrode 5 was 450 nm, and D2/D1 = 0.11 (11%).

(Measurement of Capacitance)

The capacitance of each of the photoelectric conversion elements according to Examples and Comparative Example was measured.

In measurement of the capacitance of the photoelectric conversion element, the impedances of the obtained photoelectric conversion element at alternating-current frequencies from 10 Hz to 10 kHz were measured in a state in which light did not enter the photoelectric conversion element by using an LCR meter (E4980A made by Keysight Technologies, Inc.) connected to the lower electrode 2 and the upper electrode 5, and the average value of the capacitances at the frequencies was calculated. The capacitance when 10 V was applied as the first bias voltage between the lower electrode 2 and the upper electrode 5 was denoted by C1, and the capacitance when -1 V was applied as the second bias voltage between the lower electrode 2 and the upper electrode 5 was denoted by C2. It was defined that a bias voltage when the bias voltage was applied so that the potential of the upper electrode 5 became higher than the potential of the lower electrode 2 had a "positive" value.

(C2 - C1)/C1 was less than or equal to 1 in the photoelectric conversion elements according to Examples 1 to 3, and (C2 - C1)/C1 was greater than 1 in the photoelectric conversion element according to Comparative Example 1.

(Making of Imaging Device)

By using the photoelectric conversion element according to Example 1 as the photoelectric converter of each pixel 24, the charge detection circuit 35 connected to the lower electrode 2 via the charge accumulation node 34 was formed, and an imaging device according to Example 1 was made. Also regarding each of the photoelectric conversion elements according to Examples 2 and 3 and Comparative Example 1, as with Example 1, by using the photoelectric conversion element as the photoelectric converter of each pixel 24, imaging devices according to Examples 2 and 3 and Comparative Example 1 were made.

(Measurement of Random Noise)

Regarding the imaging devices according to Examples and Comparative Example, in order to evaluate noise, an output detected by the charge detection circuit 35 of each pixel 24 was acquired. To be specific, in a state in which light did not enter the imaging device, when a predetermined time elapsed after the potential of the charge accumulation node 34 of each pixel 24 had been reset, an output detected by the charge detection circuit 35 based on the quantity of charges accumulated in the charge accumulation node 34 was acquired. At this time, a voltage of -1 V relative to the potential of the lower electrode 2 was applied between the lower electrode 2 and the upper electrode 5. That is, a voltage such that the potential of the upper electrode 5 became lower than the potential of the lower electrode 2 was applied between the lower electrode 2 and the upper electrode 5. Then, the standard deviation of outputs from the pixels 24 was calculated as random noise.

Fig. 10 is a graph illustrating the relationship between (C2 - C1)/C1 and random noise in the imaging devices according to Examples and Comparative Example. Fig. 11 is a graph illustrating the relationship between D2/D1 and random noise in the imaging devices according to Examples and Comparative Example. In Figs. 10 and 11, the vertical axis represents random noise. The value of random noise along the vertical axis is normalized in such a way that the value of random noise when the dynamic range is 80 dB, which is equivalent to that of human eye, is 1 with respect to the saturated signal quantity of the imaging devices according to Examples and Comparative Example. In this case, the dynamic range is $20\log_{10}$(saturated signal quantity/random noise). In Fig. 10, the horizontal axis represents (C2 - C1)/C1, and in Fig. 11, the horizontal axis represents D2/D1. Black dots in Figs. 10 and 11 correspond to, in ascending order of random noise, the results of measuring random noise of the imaging devices according to Example 3, Example 2, Example, 1, and Comparative Example 1.

As illustrated in Figs. 10 and 11, it can be seen that, in an imaging device in which (C2 - C1)/C1 $\leq$ 1 is satisfied and an imaging device in which D2/D1 $\geq$ 0.25 (25%) is satisfied, random noise of the imaging device is reduced and a wide dynamic range of greater than or equal to 80 dB, which is equivalent to that of human eye, can be realized.

In this way, with an imaging device according to the present disclosure, because (C2 - C1)/C1 $\leq$ 0.1 and D1/D2 $\geq$ 0.25 (25%) are satisfied as in the imaging devices according to Examples 1 o 3, an imaging device in which noise is reduced is realized. This is presumably because, as described above, since variation in the quantity of charges accumulated in the photoelectric converter is small, it is possible to reduce the influence of the dispersion of the quantity of charges accumulated in the photoelectric converter on the charge accumulation node 34 electrically connected to the photoelectric converter.

Heretofore, an imaging device according to the present disclosure has been described based on embodiments and Examples. However, the present disclosure is not limited to these embodiments and Examples. Without departing from the gist of the present disclosure, the scope of the present disclosure includes configurations in which various modifications that a person having ordinary skill in the art can conceive are made on the embodiments and Examples and other configurations that are constructed by combining some of the constituent elements of the embodiments and Examples.

Industrial Applicability

An imaging device according to the present disclosure is applicable to various camera systems, such as a medical camera, a monitor camera, a car-mounted camera, a distance measurement camera, a microscope camera, a drone camera, and a robot camera, and sensor systems.

Reference Signs List

1 support substrate
2 lower electrode
3, 6 charge blocking layer
4 photoelectric conversion layer
4A donor semiconductor material
4B acceptor semiconductor material
5 upper electrode
10, 11 photoelectric conversion element
10A photoelectric converter
19 voltage supply circuit
20 horizontal signal readout circuit
21 amplification transistor
22 reset transistor
23 address transistor
21D, 21S, 22D, 22S, 23S impurity region
21G, 22G, 23G gate electrode
21X, 22X, 23X gate insulating layer
24 pixel
25 vertical scanning circuit
26 counter electrode signal line
27 vertical signal line
28 load circuit
29 column signal processing circuit
31 power source wiring line
32 differential amplifier
33 feedback line
34 charge accumulation node
35 charge detection circuit
36 address signal line
37 reset signal line
40 semiconductor substrate
41 element separation region
50 interlayer insulating layer
51, 53, 54 contact plug
52 wiring
60 color filter
61 microlens
100 imaging device

**Claims**

**1.** An imaging device comprising:

pixels,

wherein each of the pixels includes

a first electrode,
a second electrode that is disposed to face the first electrode, and
a photoelectric conversion layer that is positioned between the first electrode and the second electrode, includes a donor semiconductor material and an acceptor semiconductor material, and generates electrons and holes,

wherein, between the first electrode and the second electrode, a first bias voltage is applied in a first period that is an exposure period and a second bias voltage that is different from the first bias voltage is applied in a second period that is a non-exposure period, and
wherein

$$(C2 - C1)/C1 \leq 1$$

is satisfied,
where C1 is a capacitance between the first electrode and the second electrode when the first bias voltage is applied between the first electrode and the second electrode, and C2 is the capacitance between the first electrode and the second electrode when the second bias voltage is applied between the first electrode and the second electrode.

**2.** The imaging device according to claim 1, wherein a photoelectric conversion efficiency of the pixels in the first period is different from the photoelectric conversion efficiency of the pixels in the second period.

**3.** The imaging device according to claim 1,

wherein the imaging device operates by using a global shutter method in which all exposure periods of the pixels are uniform,
wherein each of the pixels further includes a charge accumulation region that is electrically connected to the first electrode and accumulates signal charges that are either the electrons or the holes, and
wherein the first period is a period for accumulating the signal charges in the charge accumulation region.

**4.** The imaging device according to claim 3, wherein the electrons and the holes in the photoelectric conversion layer recombine when the second bias voltage is applied between the first electrode and the second electrode.

**5.** The imaging device according to claim 3, wherein the photoelectric conversion layer has photoelectric conversion sensitivity when the first bias voltage is applied between the first electrode and the second electrode.

**6.** The imaging device according to any one of claims 1 to 5, further comprising:
a voltage supply circuit that selectively applies, between the first electrode and the second electrode, a bias voltage such that a potential of the second electrode relative to the first electrode becomes a positive potential and a bias voltage such that the potential of the second electrode relative to the first electrode becomes a negative potential.

**7.** An imaging device comprising:

pixels,
wherein each of the pixels includes

a first electrode,
a second electrode that is disposed to face the first electrode,
a photoelectric conversion layer that is positioned between the first electrode and the second electrode, includes a donor semiconductor material and an acceptor semiconductor material, and generates electrons and holes,
a first charge blocking layer that is positioned between the first electrode and the photoelectric conversion layer, and
a charge accumulation region that is electrically connected to the first electrode and accumulates signal charges that are either the holes or the electrons,

wherein, between the first electrode and the second electrode, a first bias voltage is applied in a first period and a second bias voltage that is different from the first bias voltage is applied in a second period, and
wherein a thickness of the first charge blocking layer is greater than or equal to 25% of a shortest distance between the first electrode and the second electrode.

**8.** The imaging device according to claim 7, wherein the thickness of the first charge blocking layer is greater than or equal to 10 nm.

**9.** The imaging device according to claim 7 or 8,

wherein the signal charges are the holes,
wherein the first charge blocking layer includes a first semiconductor material, and
wherein a difference between an ionization potential of the first semiconductor material included in the first charge blocking layer and an ionization potential of the donor semiconductor material included in the photoelectric conversion layer is less than or equal to 1 eV.

**10.** The imaging device according to claim 7 or 8,

wherein the signal charges are the electrons,
wherein the first charge blocking layer includes a first semiconductor material, and
wherein a difference between an electron affinity of the first semiconductor material included in the first charge blocking layer and an electron affinity of the acceptor semiconductor material included in the photoelectric conversion layer is less than or equal to 1 eV.

**11.** The imaging device according to claim 7, wherein each of the pixels further includes a second charge blocking layer that is positioned between the second electrode and the photoelectric conversion layer.

**12.** The imaging device according to claim 11, wherein a thickness of the second charge blocking layer is greater than or equal to 5 nm.

**13.** The imaging device according to claim 11 or 12,

wherein the signal charges are the holes,
wherein the second charge blocking layer includes a second semiconductor material, and
wherein a difference between an electron affinity of the second semiconductor material included in the second charge blocking layer and an electron affinity of the acceptor semiconductor material included in the photoelectric conversion layer is less than or equal to 1 eV.

**14.** The imaging device according to claim 11 or 12,

wherein the signal charges are the electrons,
wherein the second charge blocking layer includes a second semiconductor material, and
wherein a difference between an ionization potential of the second semiconductor material included in the second charge blocking layer and an ionization potential of the donor semiconductor material included in the photoelectric conversion layer is less than or equal to 1 eV.

FIG. 1

FIG. 2

FIG. 3

## FIG. 4

# FIG. 5

# FIG. 6

# FIG. 7

# FIG. 8

FIG. 9

FIG. 10

FIG. 11

## INTERNATIONAL SEARCH REPORT

| | International application No. |
|---|---|
| | **PCT/JP2024/013630** |

| **A.** | **CLASSIFICATION OF SUBJECT MATTER** |
|---|---|

*H01L 27/146*(2006.01)i; *H04N 25/70*(2023.01)i
FI: H01L27/146 E; H04N25/70

According to International Patent Classification (IPC) or to both national classification and IPC

| **B.** | **FIELDS SEARCHED** |
|---|---|

Minimum documentation searched (classification system followed by classification symbols)

H01L27/146; H04N25/70

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | WO 2022/124088 A1 (PANASONIC INTELLECTUAL PROPERTY MANAGEMENT CO., LTD.) 16 June 2022 (2022-06-16)<br>paragraphs [0059]-[0072], [0083]-[0086], [0104], [0115], [0161], claims 1, 13, 15, fig. 1-4, 8 | 7-8, 11 |
| Y | paragraphs [0059]-[0072], [0083]-[0086], [0104], [0115], [0161], claims 1, 13, 15, fig. 1-4, 8 | 9-10, 12-14 |
| Y | WO 2021/220820 A1 (PANASONIC INTELLECTUAL PROPERTY MANAGEMENT CO., LTD.) 04 November 2021 (2021-11-04)<br>paragraphs [0054], [0111]-[0112], [0123], [0130]-[0145] | 9-10, 12-14 |
| A | entire text, all drawings | 1-6 |
| A | JP 2017-188917 A (PANASONIC INTELLECTUAL PROPERTY MANAGEMENT CO., LTD.) 12 October 2017 (2017-10-12)<br>entire text, all drawings | 1-14 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **04 June 2024** | **18 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

# EP 4 697 385 A1

### INTERNATIONAL SEARCH REPORT
#### Information on patent family members

| Patent document cited in search report | | | Publication date (day/month/year) | Patent family member(s) | | | Publication date (day/month/year) |
|---|---|---|---|---|---|---|---|
| WO | 2022/124088 | A1 | 16 June 2022 | US | 2023/0283927 | A1 | |
| | | | | paragraphs [0071]-[0084], [0095]-[0098], [0116], [0127], [0173], claims 1, 14, 16, fig. 1-4, 8 | | | |
| | | | | CN | 116472717 | A | |
| WO | 2021/220820 | A1 | 04 November 2021 | US | 2023/0045630 | A1 | |
| | | | | paragraphs [0066], [0123]-[0124], [0134], [0140]-[0155] | | | |
| | | | | CN | 115398626 | A | |
| JP | 2017-188917 | A | 12 October 2017 | US | 2018/0020171 | A1 | |
| | | | | CN | 107113385 | A | |

Form PCT/ISA/210 (patent family annex) (July 2022)

**EP 4 697 385 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007311647 A
- JP 2012094660 A
- JP 2018092990 A